# EUROPÄISCHE PATENTSCHRIFT

(11) **EP 2 657 713 B1**
(45) Veröffentlichungstag und Bekanntmachung des Hinweises auf die Patenterteilung: **01.08.2018**
(21) Anmeldenummer: 12165250.7
(22) Anmeldetag: 24.04.2012
(51) Int. Cl.: G01R 27/26, G01F 23/26

(54) **Vorrichtung und Verfahren zur Bestimmung einer Messkapazität**
Method and device for determining a measurement capacity
Procédé et dispositif destinés à la détermination d'une capacité de mesure

(43) Veröffentlichungstag der Anmeldung: 30.10.2013
(73) Patentinhaber: VEGA Grieshaber KG, 77709 Wolfach (DE)
(72) Erfinder: Mellert, Martin, 77790 Steinach (DE)
(74) Vertreter: Westphal, Mussgnug & Partner Patentanwälte mbB

(56) Entgegenhaltungen:
- EP-A1- 2 330 478
- DE-A1- 19 946 180
- US-A- 3 805 149
- US-A- 4 908 784
- US-A1- 2001 028 262
- US-A1- 2008 169 826
- US-B1- 8 081 013

## Beschreibung

Die vorliegende Erfindung betrifft eine Messvorrichtung sowie ein Verfahren zur Bestimmung einer Messkapazität.

Die Bestimmung einer Messkapazität wird beispielsweise im Bereich der Druckmessung eingesetzt, bei der sich eine Messkapazität abhängig von einem auf eine Messmembran wirkenden Druck verändert.

Allgemein bekannt ist es, eine Messkapazität durch eine Frequenzmessung einer Messfrequenz eines Messoszillators, der abhängig von der Messkapazität schwingt, zu bestimmen. Zu diesem Zweck ist ein Taktoszillator vorgesehen, der in einer Abtastfrequenz schwingt und es wird mit einem Flankenzähler die Anzahl von Taktschwingungen während einer bestimmten Anzahl von Messschwingungen erfasst. Durch die Kenntnis der Abtastfrequenz ist es möglich, anhand der Anzahl der gezählten Flanken eine Periodendauer der Messschwingungen zu bestimmen und ausgehend davon eine Frequenz der Messschwingungen zu errechnen. Basierend auf der Frequenz der Messschwingungen und in Kenntnis der Auslegung des Messoszillators ist es dann möglich, die Größe der Messkapazität zum jeweiligen Zeitpunkt zu erfassen und im Falle einer Druckmessung abhängig von einer Ausgestaltung der verwendeten Druckmesszelle einen Rückschluss auf den einwirkenden Druck zu führen. Eine solche Messvorrichtung zur Bestimmung einer Messkapazität ist aus US 3,805,149 bekannt. In EP 2 330 478 A1 ist außerdem eine Schaltung zur Messwertverfeinerung beschrieben.

Im Allgemeinen ist es so, dass bei einer Messwertbestimmung bei Sensoren durch eine Frequenzmessung die erzielbare Auflösung durch die Abtastfrequenz des Taktoszillators sowie die Dauer einer Messung limitiert ist. Soll beispielsweise mit einer Abtastfrequenz von 1 MHz eine Auflösung von 14 Bit erreicht werden, so ist eine Messzeit von 1 ms x 2¹⁴ = 16,384 ms notwendig.

Soll die Auflösung weiter erhöht werden, ist eine höhere Messzeit erforderlich oder es ist notwendig, die Abtastfrequenz entsprechend zu erhöhen.

Um zuverlässige Messungen zu erreichen ist es in der Messtechnik jedoch gewünscht, eine vorbestimmte Messzeit nicht zu überschreiten. Soll dennoch eine erhöhte Auflösung erreicht werden, so ist nach dem Stand der Technik zwangsläufig eine Erhöhung der Abtastfrequenz notwendig. Eine solche Erhöhung der Abtastfrequenz beginnt jedoch einen erhöhten Stromverbrauch, was ebenfalls zunehmend als negativ empfunden wird.

Ein erster Ansatz zu Lösung dieser Probleme versucht eine Erhöhung der Auflösung dadurch zu erreichen, dass das Messsignal einer Kaskade von Verzögerungsgliedern zugeführt wird, deren jeweils zueinander verzögerte Ausgangssignale einer dazu parallel geschalteten Kaskade von Komparatoren zugeführt werden, die die zueinander verzögerten Messsignale mit dem Abtastsignal vergleichen.

Für den Fall, dass ein solches Verzögerungsglied das ihm zugeführte Signal um beispielsweise ein Viertel der Periodendauer der Abtastfrequenz verzögert, kann die Auflösung auf diese Weise um 2 Bit erhöht werden.

In diesem Ansatz wird es jedoch als nachteilig empfunden, dass der Betrieb der Verzögerungsglieder, der Komparatoren sowie eines Registers, in dem die von den Komparatoren erzeugten Vergleichswerte gespeichert werden ebenfalls einen erhöhten Stromverbrauch bedeutet und gleichzeitig Messfehler aufgrund der voneinander unabhängig schwingenden Oszillatoren auftreten.

Es ist die Aufgabe der vorliegenden Erfindung eine Messvorrichtung sowie ein Verfahren zur Bestimmung einer Messkapazität anzugeben, bei denen die Probleme aus dem Stand der Technik beseitigt sind.

Diese Aufgabe wird durch eine Messvorrichtung mit den Merkmalen des Patentanspruchs 1 sowie ein Verfahren mit den Merkmalen des Patentanspruchs 10 gelöst.

Eine erfindungsgemäße Messvorrichtung zur Bestimmung einer Messkapazität weist einen Taktoszillator, der in einer Abtastfrequenz schwingt, einen Messoszillator, der abhängig von einer Messkapazität in einer Messfrequenz schwingt und einen Flankenzähler auf, der die Anzahl von Taktschwingungen während einer bestimmten Anzahl von Messschwingungen zählt, wobei eine Schaltung zur Messwertverfeinerung vorgesehen ist, die durch eine Messflanke einer letzten abgetasteten Messschwingung gestartet und durch eine gleich orientierte und unmittelbar folgende Flanke einer darauffolgenden Taktschwingung gestoppt wird. Die Schaltung zur Messwertverfeinerung ist mit einer Mehrzahl von in Reihe geschalteten Verzögerungsgliedern ausgestaltet, denen das Messsignal zuführbar ist und an denen ausgangsseitig jeweils das zeitlich zueinander verzögerte Messsignal als Vergleichssignal abgreifbar ist. Die Schaltung zur Messwertverfeinerung weist ferner eine Mehrzahl von Komparatoren auf, denen einerseits das Taktsignal und andererseits jeweils eines der Vergleichssignale zugeführt ist, wobei die Vergleichssignale je mit dem Taktsignal verglichen werden und das Ergebnis dieses Vergleiches einen Anteil des Taktsignals repräsentiert, der der Anzahl von Taktschwingungen abgezogen wird.

Dadurch, dass die Schaltung zur Messwertverfeinerung nur teilweise, d. h. insbesondere am Ende eines Messzyklus aktiviert wird, wird der Energieverbrauch der Schaltung zur Messwertverfeinerung imenz reduziert. Dauert ein gesamter Messzyklus beispielsweise etwa 5 ms, so kann die Dauer der Aktivierung der Schaltung zur Messwertverfeinerung um 80%, d. h. auf etwa 1 ms reduziert werden. Entsprechend sind die von der Schaltung zur Messwertverfeinerung verbrauchte Energie.

Eine weitere Verbesserung der erzielten Messwerte kann dadurch erreicht werden, dass der Messoszillator taktsynchron zu dem Taktoszillator gestartet wird. Bei voneinander unabhängig schwingenden Oszillatoren ist bei der ersten Abtastung des Messsignals bzw. bei der ersten durch den Flankenzähler gezählten Flanke des Taktsignals nicht bekannt, in welchem Zustand sich das Messsignal aktuell befindet. Die erste erfasste Flanke kann damit um bis zu eine halbe Periodendauer der Abtastfrequenz variieren. Abhängig vom aktuellen Schwingungszustand des Taktoszillators relativ zu dem Messoszillator.

Durch ein taktsynchrones Starten des Messoszillators zu dem Taktoszillator wird eine definierte Ausgangssituation erreicht, so dass die Genauigkeit der ermittelten Messwerte weiter steigt.

Bevorzugterweise wird die Anzahl der Messflanken, während derer von dem Flankenzähler die Anzahl von Taktschwingungen ermittelt wird, abhängig von einer vorgegebenen Messzeit bestimmt. Die Messzeit kann beispielsweise wenigstens 5 ms betragen. Die Anzahl der Messflanken wird dann mit Hilfe einer Hysterese versehenen Schaltung so eingestellt, dass sie beispielsweise bei Unterschreiten einer Messzeit von 5 ms um 1 erhöht und bei Überschreiten einer Messdauer von 6 ms um 1 erniedrigt wird.

In einer bevorzugten Ausgestaltungsform werden insbesondere fallende Messflanken durch den Flankenzähler erfasst. Eine derartige Ausgestaltung ist insbesondere dann sinnvoll, wenn der Messoszillator und der Taktoszillator taktsynchron mit einer steigenden Flanke gestartet werden. Die Anzahl der fallenden Flanken gibt dann eindeutig Auskunft über die Anzahl der Schwingungen des Taktoszillators sowie die zugeordnete Messzeit.

Um einen unmittelbaren Einfluss der Messkapazität auf die Frequenz des Messoszillators zu gewährleisten ist diese bevorzugt in einem Schwingkreis angeordnet, der den Messoszillator bildet. Es kann auf diese Weise gewährleistet werden, dass eine Änderung der Messkapazität unmittelbar und beispielsweise ohne eine dazwischenliegende Spannungswandlung Einfluss auf die Frequenz des Messoszillators hat.

Bei einer Anzahl von n-Verzögerungsgliedern, die das Messsignal jeweils um 1/n des Taktsignals verzögern, kann die Lage der letzten fallenden Flanke auf 1/n der Periodendauer des Taktsignals genau bestimmt werden. Die Ausgangswerte der vorgesehenen Komparatoren werden dazu bevorzugt in ein Register geschrieben, das nach Abschluss der Messwertverfeinerung ausgelesen wird.

Die Verzögerungsglieder sind dazu bevorzugt mit identischer Verzögerung ausgebildet.

Das letztendlich erreichbare Messsignal kann abhängig von der Anzahl der verwendeten Verzögerungsstufen und Komparatoren um log_{2N} Bit vergrößert werden. Beispielsweise kann durch das Vorsehen von vier Verzögerungsstufen und Komparatoren eine Erhöhung der Auflösung um log₂⁴ = 2 Bit erreicht werden. Um eine Erhöhung der Auflösung um 3 Bit zu erreichen wäre eine Anzahl von n = 2³ = 8 Verzögerungsgliedern und Komparatoren notwendig.

Die Verzögerungsglieder sind beispielsweise als RC-Glied mit einem nachgeschalteten Verstärker ausgebildet sein.

Bei einem erfindungsgemäßen Verfahren zur Messung einer Messkapazität schwingt ein Taktoszillator mit einer Abtastfrequenz und ein Messoszillator abhängig von der Messkapazität mit einer Messfrequenz, wobei ein Flankenzähler die Anzahl von Taktschwingungen während einer bestimmten Anzahl von Messschwingungen zählt und eine Schaltung zur Messwertverfeinerung durch eine Messflanke einer letzten abgetasteten Messschwingung gestartet und durch eine gleich orientierte Flanke einer unmittelbar darauf folgenden Taktschwingung gestoppt wird.

Durch ein Starten der Messwertverfeinerung durch eine Messflanke einer letzten abgetasteten Messschwingung und ein Stoppen der Schaltung zur Messwertverfeinerung durch eine gleich orientierte Flanke einer unmittelbar darauf folgenden Taktschwingung für die Dauer des Schrittes der Messwertverfeinerung erheblich reduziert und dadurch der Verbrauch an Ressourcen durch die Messwertverfeinerung ebenfalls verringert.

Um eine weiteren Erhöhung der Messgenauigkeit des erfindungsgemäßen Verfahrens zu erreichen wird der Messoszillator bevorzugt taktsynchron zu dem Taktoszillator gestartet. Auf diese Weise kann eine Schwankung zu Beginn der Messung, die bis zu einer halben Taktperiode betragen kann, vermieden.

Die Anzahl an Messschwingungen wird bevorzugt abhängig von einer vorgegebenen Messzeit eingestellt. Wird beispielsweise eine Messzeit von wenigstens 5 ms vorgegeben, so kann die Anzahl der Messschwingungen beispielsweise so eingestellt werden, dass bei Unterschreiten der Messzeit von 5 ms die Anzahl der Messschwingungen um 1 erhöht und bei Überschreiten einer Messzeit von beispielsweise 6 ms die Anzahl der Messschwingungen um 1 erniedrigt wird.

Nach Erreichen der vorgegebenen Anzahl von Messflanken wird die Messung mit einer darauffolgenden, bevorzugt gleich orientierten Messflanke gestoppt. Ohne Einsatz der Schaltung zur Messwertverfeinerung wird das so ermittelte Messsignal und die daraus bestimmte Messkapazität von dem tatsächlichen Wert der Messkapazität in der Regel abweichen, da die letzte gezählte Flanke der Taktschwingung naturgemäß nach der letzten Flanke der Messschwingung liegt.

In einer Ausgestaltungsform des erfindungsgemäßen Verfahrens wird zur Messwertverfeinerung das Messsignal mehrfach verzögert. Das verzögerte Messsignal wird mit dem Taktsignal verglichen und das Ergebnis dieses Vergleichs, das einen Anteil des Taktsignals repräsentiert, von der Anzahl der ermittelten Taktschwingungen subtrahiert.

Die Schaltung zur Messwertverfeinerung wird bevorzugt durch eine fallende Flanke des Messsignals gestartet und durch eine unmittelbare darauffolgende Flanke des Taktsignals gestoppt.

Die Anzahl der so ermittelten Flanken kann dann um den von der Messwertverfeinerung ermittelten Bruchteils eines Taktsignals reduziert werden, so dass die erhöhte Genauigkeit bei der Messwertermittlung erreicht wird.

Die vorliegende Erfindung wird nachfolgend anhand eines Ausführungsbeispiels und Bezugnahme auf die beigefügten Figuren eingehend erläutert. Es zeigen:
- Figur 1: ein vereinfachtes Blockschaltbild einer Druckmessvorrichtung, bei der die erfindungsgemäße Messvorrichtung zum Einsatz kommt,
- Figur 2: beispielhafte Signalverläufe des Taktsignals sowie des Messsignals,
- Figur 3: eine beispielhafte Schaltung zur Messwertverfeinerung, und
- Figur 4: beispielhafte Signalverläufe des Taktsignals des Messsignals, der verzögerten Messsignale sowie der Ausgangssignale der Komparatoren in Figur 3.

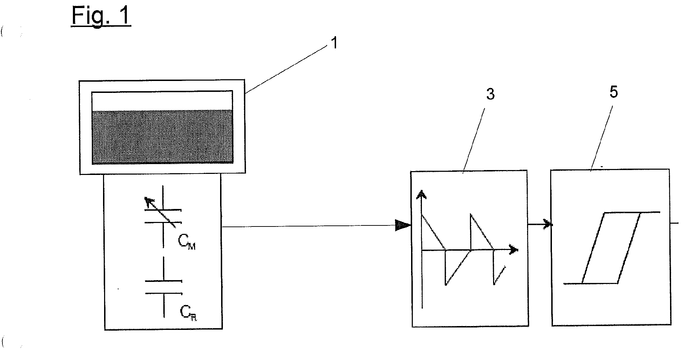

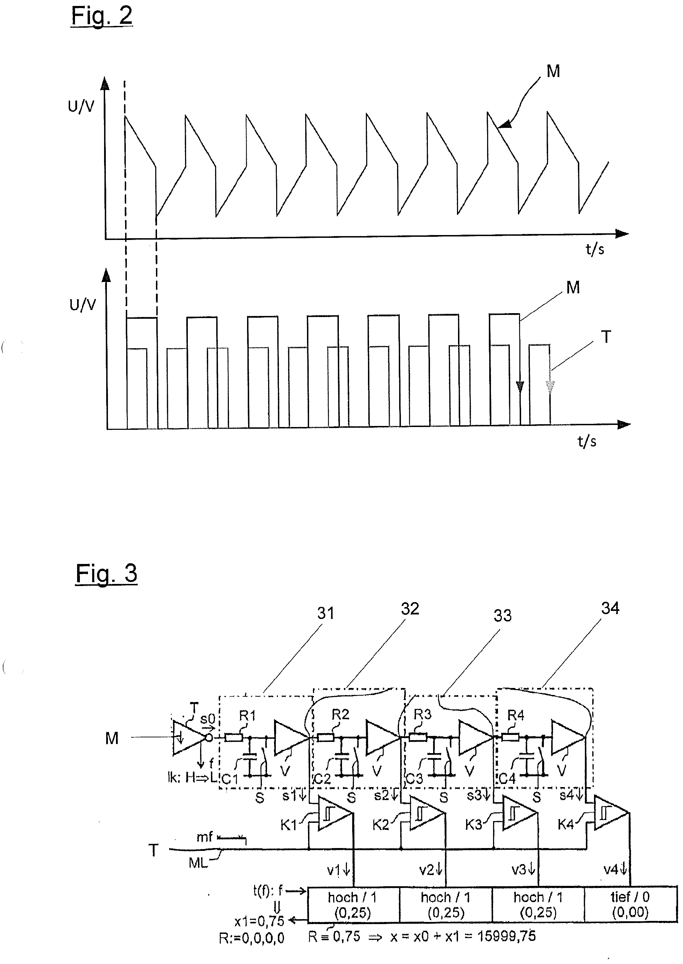

Figur 1 zeigt ein vereinfachtes Blockschaltbild einer Füllstandmessvorrichtung, bei der eine Messvorrichtung zur Bestimmung einer Messkapazität C_{M} vorgesehen ist. Die Füllstandmessvorrichtung weist wenigstens eine Messzelle 1 auf, bei sich abhängig von einem auf die Messzelle 1 einwirkenden Druck die Messkapazität C_{M} eines Kondensators, der beispielsweise als Plattenkondensator ausgebildet ist, verändert. Zur Normierung der Messkapazität kann außerdem eine Referenzkapazität C_{R} vorgesehen sein, mit Hilfe derer erreicht wird, dass der ausgegebene Wert im Wesentlichen dimensionslos ist. Die Messkapazität ist Bestandteil eines Messoszillators 3, der aus einem Schwingkreis mit der Messkapazität C_{M} gebildet ist. Der Messoszillator 3 schwingt dann abhängig von der Größe der Messkapazität C_{M} in der Messfrequenz F_{M} entsprechend der in Figur 2 im oberen Teil dargestellten Spannungsverläufe. Die sägezahnartigen Spannungsverläufe des Messoszillators 3 können mit Hilfe eines Komparators 5, der beispielsweise als Schmidt-Trigger ausgebildet sein kann in rechteckförmige Signalverläufe, wie sie im unteren Teil von Figur 2 dargestellt sind, gewandelt werden. Im unteren Teil der Figur 2 ist außerdem ein Taktsignal eines Taktoszillators 7 dargestellt, der in einer Abtastfrequenz f_{A} schwingt. Wie Figur 2 entnommen werden kann, beginnt das Messsignal synchron zu dem Taktsignal zu schwingen, so dass in diesem Bereich keine zeitliche Verzögerung auftritt.

In dem in Figur 2 dargestellten Ausführungsbeispiel ist die Anzahl von Messschwingungen, während derer durch einen Flankenzähler 9 die Anzahl an Taktschwingungen ermittelt wird auf 7 festgelegt. Diese Anzahl ist abhängig von einer vorgegebenen Messzeit gewählt, die beispielsweise aufgrund der Anforderungen an eine Messhäufigkeit oder eine Messgeschwindigkeit oder ein gewünschte Auflösung gewählt ist.

Der Flankenzähler 9 zählt einerseits die Anzahl der Messschwingungen, im vorliegenden Beispiel die Anzahl der fallenden Flanken des Messsignals sowie die Anzahl der fallenden Flanken des Taktsignals. Sobald die 7. fallende Flanke des Messsignals erfasst wird, wird die Zählung der fallenden Flanken des Taktsignals mit der unmittelbar auf die 7. fallende Flanke des Messsignals folgenden fallenden Flanke des Tastsignals gestoppt. Wird nun basierend auf der Kenntnis der Abtastfrequenz des Taktoszillators und mit Hilfe der Anzahl der gemessenen Messschwingungen auf die Messfrequenz f_{M} rückgeschlossen, so wird aufgrund der Zeitdifferenz zwischen der letzten Messflanke und der letzten Taktflanke ein Fehler von bis zu einer kompletten Taktperiode gemacht.

Um einen verbesserten Messwert zu erreichen und die Auflösung der Messung damit zu erhöhen ist eine Schaltung zur Messwertverfeinerung, wie sie in Figur 3 dargestellt ist, vorgesehen. Der Schaltung zur Messwertverfeinerung ist das durch einen invertierenden Verstärker invertierte und verstärkte Messsignal 20 als Eingangssignal S₀ zugeführt. Die Schaltung zur Messwertverfeinerung weist im vorliegenden Ausführungsbeispiel 4 in Reihe geschaltete Verzögerungsglieder 31 bis 34 auf. Die Verzögerungsglieder 31 bis 34 sind identisch aufgebaut und weisen jeweils ein RC-Glied sowie einen nachgeschalteten nicht invertierenden Verstärker auf. Um ein kontrolliertes Rücksetzen der Verzögerung wieder zu ermöglichen, kann der vorgesehene Kondensator jeweils mit Hilfe eines Schalters S überbrückt werden.

Ausgangsseitig ist an den Verzögerungsgliedern 31 bis 34 das jeweils zum Eingangssignal verzögerte Messsignal als Vergleichssignal s1 bis s4 abgreifbar. Die Vergleichssignale s1 bis s4 sind jeweils einem Komparator K1 bis K4 zugeführt, dem als zweites Signal das Taktsignal zugeführt ist. Ausgangsseitig ist damit an den Komparatoren K1 bis K4 jeweils ein Vergleichswert v1 bis v4 abgreifbar, der im vorliegenden Ausführungsbeispiel in ein Register R geschrieben wird. Entsprechend dem vorliegenden Ausführungsbeispiel repräsentiert damit jede in dem Register R hinterlegte Wert 1/4 der Taktperiode.

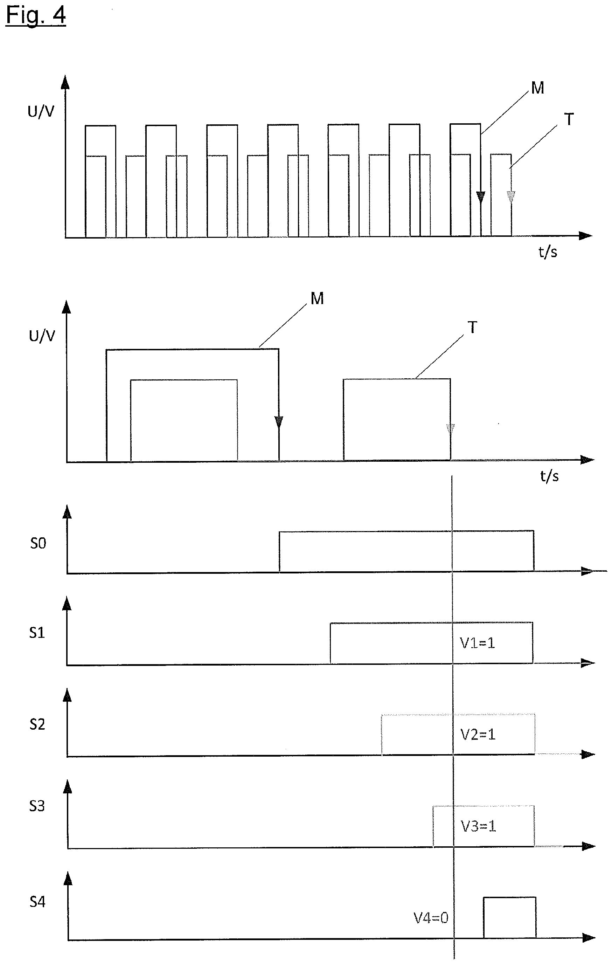

Den in Figur 4 dargestellten Signalverläufen des Messsignals M, des Taktsignals P der invertierten und verzögerten Taktsignale respektive Vergleichssignale s1 bis s4 sowie der Vergleichswerte v1 bis v4 ist das Prinzip der vorliegenden Schaltung nochmals eindeutig zu entnehmen. Aktiviert durch die fallende Flanke einer letzten Messschwingung wird das Messsignal der Schaltung zur Messwertverfeinerung zugeführt und durch den invertierenden Verstärker invertiert. Das invertierte Messsignal wird durch die Verzögerungsglieder 31 bis 34 die geeignet dimensioniert sind, jeweils um 1/4 der Taktperiode verzögert, so dass die Vergleichssignale s1 bis s4 ausgangsseitig an den Verzögerungsgliedern 31 bis 34 abgreifbar sind. Durch die Komparatoren K1 bis K4, denen die Vergleichssignale s1 bis s4 sowie das Taktsignal T zugeführt sind, werden die Vergleichswerte v1 bis v4 erzeugt. Solange an den Komparatoren K1 bis K4 an beiden Eingängen ein High-Signal anliegt mit als Vergleichswert v1 bis v4 ebenfalls ein High-Signal ausgegeben. Liegt an den Eingängen eines der Komparatoren K1 bis K4 unterschiedliche Signale an, so gibt der Komparator ein Low-Signal auf. Im vorliegenden Ausführungsbeispiel sind die Eingangssignale an den Komparatoren K1 bis K3 durch die Invertierung und mehrfache Verzögerung des Messsignals M identisch und an dem letzten Komparator K4 unterschiedlich. Dementsprechend sind die Vergleichswerte v1 bis v3 High-Signale, der Vergleichswert v4 ist ein Low-Signal. Von dem durch Zählen der Taktflanken ermittelten Messwert ist entsprechend der im vorliegenden Ausführungsbeispiel realisierten Schaltung der durch die Vergleichswerte v1 bis v4 repräsentierte Anteil einer Taktperiode zu subtrahieren.

Die Messwertverfeinerung erfasst auf diese Weise die Zeit bis zur nächsten Taktflanke, die dann von dem ermittelten Wert abzuziehen ist.

Vorteilhaft an der gezeigten Ausgestaltung, dass ein Strombedarf, der Schaltung der Messwertverfeinerung immer nur bei einem Flankenwechsel des Messsignals M auftritt. Durch eine taktsynchrone Aktivierung von Mess- und Taktoszillator 3, 7 werden auch Messfehler zur Beginn der Messung vermieden.

### Bezugszeichenliste

- 1: Messzelle
- 3: Messoszillator
- 5: Schmidt-Trigger
- 7: Taktoszillator
- 9: Flankenzähler

- 31: Verzögerungsglied
- 32: Verzögerungsglied
- 33: Verzögerungsglied
- 34: Verzögerungsglied

- C_{M}: Messkapazität
- C_{R}: Referenzkapazität
- R: Register
- S: Schalter
- M: Messsignal
- T: Taktsignal

- f_{M}: Messfrequenz
- f_{A}: Abtastfrequenz
- V: Verstärker
- R1: Widerstand
- R2: Widerstand
- R3: Widerstand
- R4: Widerstand
- C1: Kapazität
- C2: Kapazität
- C3: Kapazität
- C4: Kapazität
- K1: Komparator
- K2: Komparator
- K3: Komparator
- K4: Komparator
- s1: Vergleichssignal
- s2: Vergleichssignal
- s3: Vergleichssignal
- s4: Vergleichssignal
- v1: Vergleichswert
- v2: Vergleichswert
- v3: Vergleichswert
- v4: Vergleichswert
- s₀: invertiertes Messsignal

## Patentansprüche

1. Messvorrichtung zur Bestimmung einer Messkapazität (C_{M}),
- mit einem Taktoszillator (7), der in einer Abtastfrequenz (f_{A}) schwingt,
- einem Messoszillator (3), der abhängig von einer Messkapazität (C_{M}) in einer Messfrequenz schwingt und
- einem Flankenzähler (9), der die Anzahl von Taktschwingungen während einer bestimmten Anzahl von Messschwingungen zählt, wobei eine Schaltung zur Messwertverfeinerung vorgesehen ist,
**dadurch gekennzeichnet, dass** die Schaltung zu Messwertverfeinerung durch eine Messflanke einer letzten abgetasteten Messschwingung gestartet und durch eine gleichorientierte und unmittelbar folgende Flanke einer darauf folgenden Taktschwingung gestoppt wird, wobei die Schaltung zur Messwertverfeinerung eine Mehrzahl von in Reihe geschalteten Verzögerungsgliedern (31, 32, 33, 34) aufweist, denen das Messsignal (M) zuführbar ist und an denen ausgangsseitig jeweils das zeitlich zueinander verzögerte Messsignal (M) als Vergleichssignal (S1) abgreifbar ist, und wobei die Schaltung zur Messwertverfeinerung eine Mehrzahl von Komparatoren (K1, K2, K3, K4) aufweist, denen einerseits das Taktsignal (T) und andererseits jeweils eines der Vergleichssignale (s1, s2, s3, s4) zugeführt ist, wobei die Vergleichssignale (s1, s2, s3, s4) je mit dem Taktsignal (T) verglichen werden und das Ergebnis dieses Vergleiches einen Anteil von einer Taktperiode (P) repräsentiert, die von der Anzahl von Taktschwingungen abgezogen wird.

2. Messvorrichtung nach Anspruch 1,
**dadurch gekennzeichnet, dass** der Messoszillator taktsynchron zu dem Taktoszillator (7) gestartet wird.

3. Messvorrichtung nach einem der vorhergehenden Ansprüche,
**dadurch gekennzeichnet, dass**
die Anzahl der Messflanken abhängig von einer vorgegebenen Messzeit ist.

4. Messvorrichtung nach Anspruch 3,
**dadurch gekennzeichnet, dass**
die Messzeit 5 ms beträgt.

5. Messvorrichtung nach einem der vorhergehenden Ansprüche,
**dadurch gekennzeichnet, dass**
die Messflanke eine fallende Flanke ist.

6. Messvorrichtung nach einem der vorhergehenden Ansprüche,
**dadurch gekennzeichnet, dass**
die Messkapazität (C_{M}) in einem Schwingkreis angeordnet ist, der den Messoszillator (3) bildet.

7. Messvorrichtung nach einem der vorhergehenden Ansprüche,
**dadurch gekennzeichnet, dass**
die Verzögerungsglieder (31, 32, 33, 34) mit gleicher Verzögerung ausgebildet sind.

8. Verfahren zur Messung einer Messkapazität bei dem
- ein Taktoszillator (7) mit einer Abtastfrequenz (f_{A}) schwingt,
- ein Messoszillator (3) abhängig von der Messkapazität (C_{M}) mit einer Messfrequenz schwingt,
**dadurch gekennzeichnet, dass**
ein Flankenzähler (9) die Anzahl von Taktschwingungen während einer bestimmten Anzahl von Messschwingungen zählt und
der Messoszillator (3) taktsynchron zu dem Taktoszillator (7) gestartet wird,
und
eine Schaltung zur Messwertverfeinerung durch eine Messflanke einer letzten abgetasteten Messschwingung gestartet und durch eine gleichorientierte Flanke einer unmittelbar darauf folgenden Taktschwingung gestoppt wird, wobei
zur Messwertverfeinerung das Messsignal (M) mehrfach verzögert wird,
die verzögerten Messsignale (M) je mit dem Taktsignal (T) verglichen werden und
das Ergebnis dieses Vergleiches einen Anteil des Taktsignals repräsentiert, der der Anzahl von Taktschwingungen abgezogen wird.

9. Verfahren nach Anspruch 8,
**dadurch gekennzeichnet, dass** der Messoszillator (3) taktsynchron zu dem Taktoszillator (7) gestartet wird.

10. Verfahren nach Anspruch 8 oder 9,
**dadurch gekennzeichnet, dass**
die Anzahl an Messschwingungen abhängig von einer vorgegebenen Messzeit eingestellt wird.

11. Verfahren nach einem der Ansprüche 8 bis 10,
**dadurch gekennzeichnet, dass**
die Schaltung zur Messwertverfeinerung durch eine fallende Flanke des Messsignals (M) gestartet und durch eine unmittelbar folgende fallende Flanke des Taktsignals (T) gestoppt wird.

## Claims

1. Measuring device for the determination of a measuring capacitance (CM),
- comprising a clock oscillator (7) which oscillates at a scanning frequency (fA),
- a measuring oscillator (3) which oscillates at a measurement frequency depending upon a measuring capacitance (CM), and
- an edge counter (9) which counts the number of clock oscillations during a specific number of measuring oscillations, wherein a circuit is provided for a measurement refinement,
**characterised in that** the circuit for said measurement refinement is started by a measuring edge of a last scanned measuring oscillation and stopped by an equally oriented and immediately following edge of a subsequent clock oscillation, wherein the circuit for measurement refinement has a plurality of series-connected delay elements (31, 32, 33, 34), to which the measurement signal (M) can be supplied and at the outputs of which the respective measurement signals (M) which are delayed relative to one another can be tapped as the comparison signal (s1), and wherein the circuit for measurement refinement has a plurality of comparators (K1, K2, K3, K4), to which the clock signal (T) is supplied on the one hand and one of the comparison signals (s1, s2, s3, s4) is supplied on the other hand, wherein the comparison signals (s1, s2, s3, s4) are each compared with the clock signal (T) and the result of this comparison represents a portion of a clock period (P), which is subtracted from the number of clock oscillations.

2. Measuring device according to claim 1, **characterised in that** the measuring oscillator is started in synchronisation with the clock oscillator (7).

3. Measuring device according to one of the preceding claims, **characterised in that** the number of measuring edges is dependent upon a predetermined measurement time.

4. Measuring device according to claim 3, **characterised in that** the measurement time is 5 ms.

5. Measuring device according to one of the preceding claims, **characterised in that** the measuring edge is a falling edge.

6. Measuring device according to one of the preceding claims, **characterised in that** the measuring capacitance (CM) is arranged in an oscillating circuit which forms the measuring oscillator (3).

7. Measuring device according to one of the preceding claims, **characterised in that** the delay elements (31, 32, 33, 34) are formed with the same delay.

8. Method for the measurement of a measuring capacitance, wherein
- a clock oscillator oscillates with a scanning frequency (fA),
- a measuring oscillator (3) which oscillates with a measuring frequency depending upon the measuring capacitance (CM), **characterised in that** an edge counter (9) counts the number of clock oscillations during a specific number of measurement oscillations and the measuring oscillator (3) is started in synchronisation with the clock oscillator (7), and a circuit for measurement refinement which is started by a measuring pulse edge of a last scanned measurement oscillation and stopped by an equally oriented edge of an immediately following clock oscillation, wherein the measurement signal (M) is repeatedly delayed for the measurement refinement, the delayed measurement signals (M) are each compared with the clock signal (T) and the result of this comparison represents a portion of the clock signal which is subtracted from the number of clock oscillations.

9. Method according to claim 8, **characterised in that** the measuring oscillator (3) is started in synchronisation with the clock oscillator (7).

10. Method according to claim 8 or 9, **characterised in that** the number of measurement oscillations is set depending upon a predetermined measurement time.

11. Method according to one of claims 8 to 10, **characterised in that** the circuit for measurement refinement is started by a falling edge of the measurement signal (M) and stopped by an immediately following falling edge of the clock signal (T).

## Revendications

1. Dispositif de mesure permettant de déterminer une capacité de mesure (C_{M}),
comportant un oscillateur d'horloge (7) qui oscille à une fréquence d'échantillonnage (f_{A}),
un oscillateur de mesure (3) qui oscille à une fréquence de mesure en fonction d'une capacité de mesure (C_{M}), et
un compteur de flancs (9) qui compte le nombre d'oscillations d'horloge dans un nombre prédéfini d'oscillations de mesure, un circuit permettant d'affiner la valeur de mesure étant prévu,
**caractérisé en ce que**
le circuit permettant d'affiner la valeur de mesure est lancé par un flanc de mesure de la dernière oscillation de mesure produite par échantillonnage, et est arrêté par un flanc immédiatement suivant ayant la même orientation d'une oscillation d'horloge suivante, le circuit permettant d'affiner la valeur de mesure comportant plusieurs d'organes de temporisation (31, 32, 33, 34) branchés en série auxquels peut être transféré le signal de mesure (M), et sur lesquels peut être capté, côté sortie, en tant que signal de comparaison (S1), le signal de mesure temporisé respectif (M), et le circuit permettant d'affiner la valeur de mesure, comportant plusieurs comparateurs (K1, K2, K3, K4) auxquels est transféré, d'une part le signal d'horloge (T) et, d'autre part, l'un respectif des signaux de comparaison (s1, s2, s3, s4), les signaux de comparaison (s1, s2, s3, s4) étant respectivement comparés au signal d'horloge et le résultat de cette comparaison (s1, s2, s3, s4) représentant une partie d'une période d'horloge (T) dérivant du nombre d'oscillations d'horloge.

2. Dispositif de mesure conforme à la revendication 1,
**caractérisé en ce que**
l'oscillateur de mesure est démarré en synchronisme avec l'oscillateur d'horloge (7).

3. Dispositif de mesure conforme à l'une des revendications précédentes,
**caractérisé en ce que**
le nombre de flancs de mesure est dépendant d'une durée de mesure prédéfinie.

4. Dispositif de mesure conforme à la revendication 3,
**caractérisé en ce que**
la durée de mesure est de 5 ms.

5. Dispositif de mesure conforme à l'une des revendications précédentes,
**caractérisé en ce que**
le flanc de mesure est un flanc descendant.

6. Dispositif de mesure conforme à l'une des revendications précédentes,
**caractérisé en ce que**
la capacité de mesure (C_{M}) est montée dans un circuit oscillant qui forme l'oscillateur de mesure (3).

7. Dispositif de mesure conforme à l'une des revendications précédentes,
**caractérisé en ce que**
les organes de temporisation (31, 32, 33, 34) ont la même temporisation.

8. Procédé de mesure d'une capacité de mesure selon lequel :
- un oscillateur d'horloge (7) oscille à une fréquence d'échantillonnage (f_{A}),
- un oscillateur de mesure (3) oscille en fonction de la capacité de mesure (C_{M}) à une fréquence de mesure,
**caractérisé en ce qu'**
un compteur de flancs (9) compte le nombre d'oscillations d'horloge dans un nombre prédéfini d'oscillations de mesure, l'oscillateur de mesure (3) est démarré en synchronisme avec l'oscillateur de cadencement (7), et
un circuit permettant d'affiner la valeur de mesure est lancé par le flanc de mesure de la dernière oscillation de mesure produit par échantillonnage et est arrêté par un flanc ayant la même orientation d'une oscillation d'horloge immédiatement suivante,
procédé selon lequel,
pour permettre d'affiner la valeur de mesure, le signal de mesure (M) est temporisé plusieurs fois,
les signaux de mesure temporisés (M) sont respectivement comparés avec le signal d'horloge (T), et
le résultat de cette comparaison représente une partie du signal d'horloge dérivant du nombre d'oscillations de cadencement.

9. Procédé conforme à la revendication 8,
**caractérisé en ce que**
l'oscillateur de mesure (3) est démarré en synchronisme avec l'oscillateur d'horloge (7).

10. Procédé conforme à la revendication 8 ou 9,
**caractérisé en ce que**
le nombre d'oscillations de mesure est réglé en fonction d'une durée de mesure prédéfinie.

11. Procédé conforme à l'une des revendications 8 à 10,
**caractérisé en ce que**
le circuit permettant d'affiner la valeur de mesure est lancé par un flan descendant du signal de mesure et est arrêté par un flanc descendant immédiatement suivant du signal d'horloge (T).
